# EUROPEAN PATENT APPLICATION

(11) **EP 0 631 327 A2**
(43) Date of publication of application: **28.12.1994**
(21) Application number: 94304658.1
(22) Date of filing: 27.06.1994
(51) Int. Cl.: H01L 31/0352, H01L 31/103, H01L 27/146

(54) **Low-capacitance photosensitive elements for an image sensor array**

(30) Priority: 28.06.1993 US 82635
(71) Applicant: XEROX CORPORATION, Rochester New York 14644 (US)
(72) Inventor: Hosier, Paul A., Rochester, NY 14612 (US); Tandon, Jagdish C., Fairport, NY 14450 (US)
(74) Representative: Johnson, Reginald George

(57) **Abstract**

A photosensitive apparatus in which a photosensitive member (14) defines a photosite of a predetermined area on a surface thereof, the photosensitive member forming electron-hole pairs when the photosite is exposed to light. A collection layer (104) disposed on the photosite encompasses an area of less than the entire photosite.

## Description

The present invention relates to image sensor arrays used in raster input scanners, and in particular to photosensitive elements which minimize unintended capacitance and the incidental effects of such capacitance on signal output.

Image sensor arrays typically comprise a linear array of photosites which raster scan an image bearing document and convert the microscopic image areas viewed by each photosite to image signal charges. Following an integration period, the image signal charges are amplified and transferred to a common output line or bus through successively actuated multiplexing transistors. In the scanning process, bias and reset charges are applied in a predetermined time sequence during each scan cycle. Where the array employs two stage transfer circuits for transferring the image signal charges from the photosites, the bias charge is applied to each photosite through a charge injection transistor and the first transistor in the two stage transfer circuit. The reset charge is applied through a reset charge injection transistor and the second transistor of the two stage transfer circuit.

It has been found in applications of sensor arrays that an important design variable which must be taken into account in a high-precision device is the incidental capacitance of individual photodiodes in the array. When a photodiode is exposed to light, electron-hole pairs are created in a given region. However, these electron-hole pairs charge the "junction capacitance" within the photodiode. The extent of the capacitance of the photodiode in a given situation will vary depending on the local physical doping of the silicon, and this variable capacitance may affect the entire system. Also, the normal distribution of energy of mobile charge causes uncertainty (noise) in the charge on a capacitor at any given time, and this also affects the system. The capacitance of the photodiodes in an array thus act as a significant source of noise and voltage variation, reducing system S/N (signal/noise ratio).

The problem of junction capacitance in photodiodes has led to numerous, relatively complicated modifications of basic circuits in prior art designs. US-A-4,499,384 discloses an image sensing device having a plurality of photoreceiving elements formed on a substrate in a single array. Each element includes a photodiode and a blocking diode which are connected in series and opposite direction. In Figure 10 of the reference, a parallel extra capacitor is used in conjunction with the photodiode to make the effective junction capacitance of the photodiode substantially greater than that of the corresponding, oppositely-oriented diode.

US-A-4,763,197 discloses a charge detecting circuit including a plurality of multiplexed photodiodes. There are provided dummy capacitors corresponding to each of the photodiodes, each dummy capacitor having substantially the same capacitance as the corresponding photodiode. Separate multiplexers are connected to the photdiodes and the dummy capacitors. A differential amplifier is connected to both multiplexers to generate a photodetection signal.

US-A- 4,839,735 discloses an image sensor in which a series circuit with a switch and a capacitance element is connected in parallel with each photodiode. The switch is closed for the charge accumulation period during which charges generated within the photodiode, and the video signal is obtained in accordance with the amount of charge on the capacitance element.

US-A-4,916,307 discloses a sensor array in which each optical sensor has associated therewith a parallel capacitor, and an optically shielded mimic sensor having the same structure as that of the optical structure including a corresponding parallel capacitor. There is also provided a time constant circuit having a capacitor that may be composed partially of the parallel capacitor of the mimic sensor.

According to the present invention, there is provided a photosensitive apparatus as defined in any of the appended claims.

The present invention will be described further, by way of examples, with reference to the accompanying drawings, in which:-
Figure 1 is a sectional, elevational view showing individual layers within a photodiode according to the present invention and
Figures 2A-2I are a series of possible shapes of diffusion areas forming a collection layer for photodiodes according to the present invention.

In a preferred embodiment of the present invention, the capacitance of individual photodiodes 14 are reduced by reducing the junction area (as between charge plates) of the effective capacitor created at the p-n junction of a charged photodiode 14. One way of reducing this effective area is, of course, to simply make the photodiode smaller. However, the total area of a photodiode in the context of a raster input scanner is primarily determined by the desired resolution of the photosensitive portion of the diode. In a 400-SPI scanner having no optical reduction, the effective area of any photodiode will of necessity be dictated by the 1/400 inch pixel size. However, according to the present invention, the total effective area of a photosite may be retained while the effective area of each photodiode which is capable of functioning as a capacitor can be reduced. According to the present invention, while the photosite (the surface of the photodiode capable of being exposed to light) is of a predetermined area, the collection layer disposed on the photosite may be made to encompass an area of less than the entire photosite, thus shrinking the physical size of the junction in the photodiode and decreasing the junction capacitance.

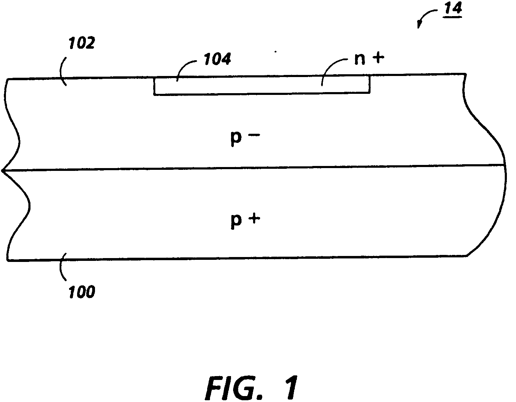

Figure 1 is a cross-sectional view through a photodiode 14 as would be used in the preferred embodiment of the present invention. The photodiode 14 comprises bulk substrate 100, a *p* - doped epitaxial layer 102, and a *n* + doped layer 104. In a typical raster input scanner application, the thickness of the epitaxial layer 102 is between about 8 and 15 micrometers, while the thickness of the layer 104 is approximately 0.3 micrometers. As shown in Figure 1, the layer 104 is disposed on the surface of the epitaxial layer 102 which is exposed to light. However, it will be seen that, unlike the typical embodiment of such a photodiode, the layer 104 is disposed only on a portion of the whole surface of photodiode 14. That is, of the entire area of the photodiode 14 forming a photosite, only a portion of this area will be encompassed by the layer 104.

As is known in the art of photosensitive devices, the purpose of layer 104 is to collect charges created by the interaction of light with single crystalline silicon so that a charge is formed which may be transferred as part of an image-processing apparatus. The charge created in both the N + layer 104 (from now on called collection layer) and in the *p* - epitaxial layer 102 is actually collected on the junction capacitor formed between these two layers, and this junction capacitor has the same dimensions as the collection layer 104. Typically, a collection layer such as 104 entirely covers the epitaxial layer 102. A characteristic of the epitaxial layer, in addition to being capable of forming electron-hole pairs when exposed to light, is a relatively long "diffusion length," which is defined as the average length through the epitaxial layer an electron hole pair will move before it recombines. This diffusion length is an important consideration because an electron formed in the epitaxial layer must travel to the collection layer in order to be detected in the form of charge. Therefore, while the collection layer 104 can be significantly smaller than the area of the entire photosite formed by the epitaxial layer 102, the collection layer 104 must encompass a sufficient amount of area on the entire photosite to be able to absorb electrons formed in the epitaxial layer even if the electrons are formed in an area of the epitaxial layer 102 which is not "under" the collection layer 104. At the same time, a charging of photodiode 14 by the interaction of light therewith will create a separation of charges at the junction between the collection layer 104 and the epitaxial layer 102. The presence of opposite-pole charges creates the junction capacitance which causes a partially-charged photodiode 14 to act as a capacitor, with the above-described detrimental results for an entire system. Therefore, by reducing the area of interface between the epitaxial layer 102 and the collection layer 104, namely by shrinking the collection layer 104, the extent of capacitance is reduced.

The junction capacitance between the oppositely-doped layers has two significant components: the area capacitance, that is, the capacitance between the interface which is horizontal in the view of Figure 1 and is dependent on the relative area of the collection layer 104 to the area of the entire photosite, and the perimeter, or sidewall, capacitance, which will be significant even if a very thin collection layer is provided. This perimeter capacitance is created along the edges of the collection layer 104, vertically in the view of Figure 1. Both such capacitances must be taken into account when designing the photodiode. It is conceivable that the collection layer 104, instead of being flush with the rest of the epitaxial layer 102, may largely lay atop a flat surface of the epitaxial layer 102 to mimimize sidewall contact, but there would still be a perimeter capacitance of some sort caused by fringe fields at the edges of the collection layer. In the actual version of the preferred embodiment, in the region where there is no diode implant foirming collection layer 104, there is a field oxide grown which does reduce the amount of silicon (Si replaced by oxide) by about 2-25 micrometers. Since the collection layer is only about .3 micrometers deep (not accounting for the depletion layer), the edge of the photodiode is butted up to the field oxide.

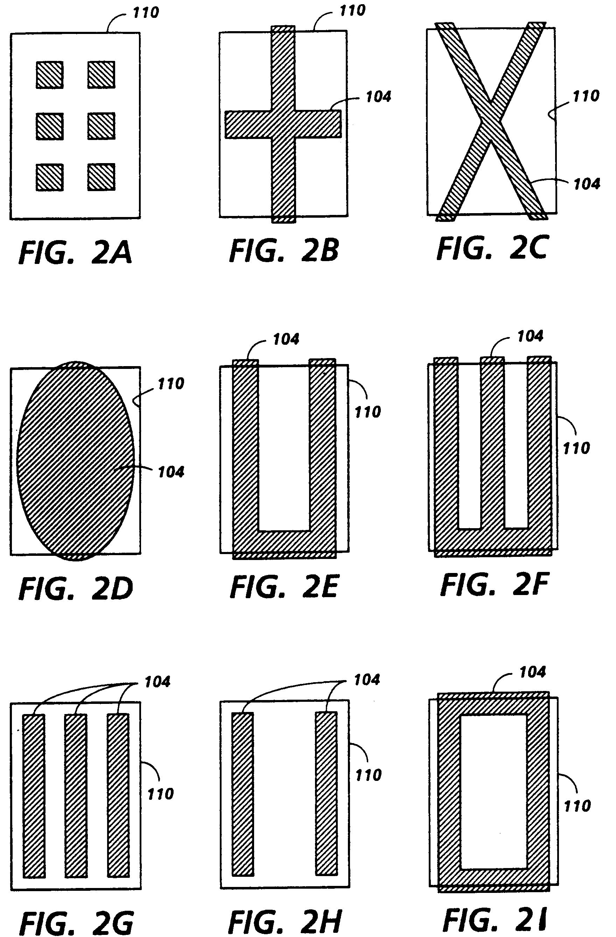

Figures 2A-2I show various possibilities for creating the necessary diffusion to form the collection layer 104 on the photosites of the image sensor array. Also shown in each Figure is the border of an opaque mask 110, which may be overlaid on the photodiode array to delineate individual photosites. As can be seen in each case, the area encompassed by collection layer 104 is significantly smaller than the total area of the photosite. Of the various proposed configurations, it will be noted that an effort is made to distribute the diffusion around the area of the photosite so that any given point within the photosite is preferably within a given length of the diffusion. Ideally, this given length would be much smaller (for almost no recombination) to the diffusion length of the epitaxial layer 102. In such a case, an electron-hole pair formed in an area beyond the diffusion but still within the photodiode is still likely to migrate successfully to the diffusion layer, and thus the fact that the collection layer is smaller in area than the entire photosite will not create a significant detriment in the amount of charge collected. It is believed that the configurations having bars or forming a loop around the photosite would be most useful in giving satisfactory performance. In the particular case of the diffusion forming an enclosed loop within the photosite, a loop would be more likely to successfully collect electrons formed within the perimeter thereof. It is also to be understood that diffusion configurations in which multiple areas of diffusion are defined within a photosite, the different areas are connected by solid conductors, not shown.

While the invention has been described with reference to the structure disclosed, it is not confined to the details set forth, but is intended to cover such modifications or changes as may come within the scope of the following claims.

## Claims

1. A photosensitive apparatus, including
a photosensitive member (14) defining a photosite of a predetermined area on a surface thereof, the photosensitive member adapted to form electron-hole pairs when the photosite is exposed to light; and
a collection layer (104) disposed on the photosite, encompassing an area of less than the entire photosite.

2. A photosensitive apparatus as claimed in claim 1, wherein the photosensitive member has a diffusion length associated therewith, and the collection layer (104) encompasses a region of the photosite within a diffusion length of any point on the photosite.

3. A photosensitive apparatus as in claim 1, wherein the photosensitive member defines an enclosed loop on the photosite and / or wherein the photosensitive member defines an enclosed loop on the photosite, at least a portion of the loop being contiguous with a boundary of the photosite.

4. A photosensitive apparatus as claimed in any one of claims 1 to 3, wherein the photosensitive member includes as epitaxial layer (102) that is *p* - doped, and wherein the collection layer (104) is *n +* doped.

5. A photosensitive apparatus as claimed in any one of claims 1 to 4, wherein the collection layer (104) is less than about 5 micrometers in thickness.

6. A photosensitive apparatus, including
a photosensitive member defining a plurality of photosites, each photosite being of a predetermined area on a surface thereof, the photosensitive member adapted to form electron-hole pairs in a zone adjacent the photosite when a photosite is exposed to light; and
a collection layer disposed on each photosite, encompassing an area of less than the entire photosite.

7. A photosensitive apparatus as claimed in claim 6, further comprising an opaque mask (110) defining the plurality of photosites.

8. A photosensitive apparatus as claimed in claim 6 or 7, further comprising a two-stage charge transfer circuit operatively associated with the collection layer of each photosite.

9. A photosensitive apparatus as claimed in claim 8, further comprising a voltage source adapted to charge each photosite with a predetermined reference voltage.

10. A photosensitive apparatus, including
an array of sensors, each sensor defining a photosite of a predetermined area on a surface of a photosensitive member, the photosensitive member adapted to form electron-hole pairs in a zone adjacent the photosite when a photosite is exposed to light and a collection layer disposed on each photosite, encompassing an area of less than the entire photosite;
a common output bus for receiving image charges accumulated by said sensors;
a two stage transistor circuit coupling each of said sensors to the output bus, said transistor circuit having first and second transistors disposed in series with one another;
amplifier means between said transistor circuit and said output bus for amplifying the image charges output by said sensors;
means for setting a preset bias charge on said sensors; and
means providing a preset reset charge to reset the input to said amplifier means.
